Europäisches Patentamt

European Patent Office

Office européen des brevets

(19)

(11) Publication number: **0 068 645 B1**

# EUROPEAN PATENT SPECIFICATION

(12)

(45) Date of publication of patent specification: **21.08.91**

(51) Int. Cl.⁵: **G11C 5/06**, G11C 11/408, G11C 11/409

(21) Application number: **82302774.3**

(22) Date of filing: **28.05.82**

(54) **A semiconductor device.**

(30) Priority: **29.05.81 JP 81042/81**

(43) Date of publication of application:
**05.01.83 Bulletin 83/01**

(45) Publication of the grant of the patent:
**21.08.91 Bulletin 91/34**

(84) Designated Contracting States:
**DE FR GB NL**

(56) References cited:
**DE-A- 2 919 166**
**US-A- 3 789 371**
**US-A- 3 848 237**
**US-A- 4 056 811**
**US-A- 4 168 538**

**IBM TECHNICAL DISCLOSURE BULLETIN, vol. 22, no. 8B, January 1980, IBM Corp.; NEW YORK (US) L. ARZUBI et al.: "Bit line cascading in semiconductor storage chips", pages 3738-3739.**

(73) Proprietor: **Hitachi, Ltd.**
**5-1, Marunouchi 1-chome**
**Chiyoda-ku, Tokyo 100(JP)**

(72) Inventor: **Itoh, Kiyoo**
**2-17-6, Gakuen-cho Higashikurume-shi**
**Tokyo(JP)**
Inventor: **Hori, Ryoichi**
**2196-125 Hirai Hinodemachi**
**Nishitama-gun Tokyo(JP)**

(74) Representative: **Ellis, Edward Lovell et al**
**MEWBURN ELLIS & CO. 2/3 Cursitor Street**
**London EC4A 1BQ(GB)**

## Description

The present invention relates to a semiconductor memory, and more particularly to a semiconductor memory device which has a high packaging density and which is advantageous for attaining a fast operation as well as a high S/N (signal-to-noise) ratio.

In semiconductor memory devices, as the packaging density is increased in order to increase its storage capacity, the capacity of a charge storage portion in each memory cell decreases. In addition, the area of the memory array on a memory chip increases, and the capacitance of a data line, and the length thereof, both increase. Accordingly, it becomes increasingly difficult to attain the features of both fast operation and high S/N ratio.

In order to obtain a large-capacity memory of fast operation and high S/N ratio, various arrangements have been proposed. An example will be described in connection with a MOS dynamic memory which is constructed of memory cells each including one transistor and one capacitor.

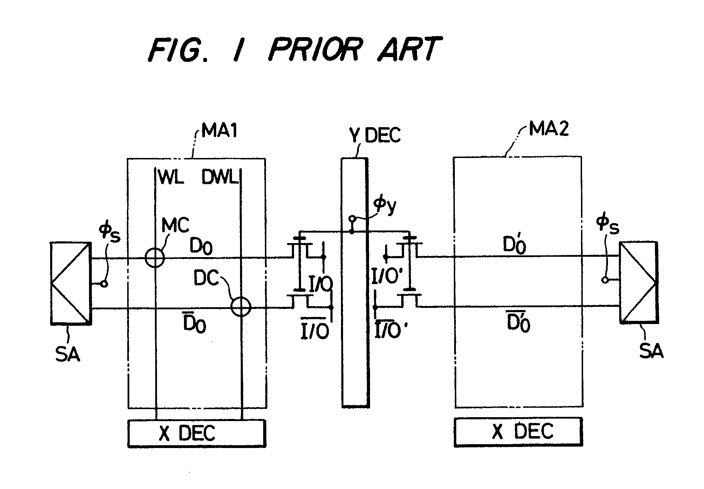

In the example shown in Figure 1 of the accompanying drawings, two memory arrays MA1 and MA2 are arranged on both the sides of a Y decoder Y DEC and have sense amplifiers SA arranged on the outer sides thereof. When a memory cell MC connected to a data line $D_0$ is selected by an X decoder X DEC, a dummy cell DC connected to a data line $\overline{D_0}$ adjoining the data line $D_0$ is selected, the difference between the potentials of the data lines $D_0$ and $\overline{D_0}$ as based on the difference of the capacitances of both the cells is amplified by the sense amplifier SA, and reading is effected through common input/output lines I/O and $\overline{I/O}$. In this manner the pair of data lines which are differentially read out are arranged adjacent to one another, to form the so-called folded data line arrangement. Therefore, the example has the merit that noise attributed to the electrical unbalance of the data lines is negligible. However, when the area of the memory array becomes large as a result of an increase in the storage capacity, the capacitance of the data line increases, so that the read-out voltage decreases. When, in this regard, the data line is shortened by increasing the number of divided memory arrays into, e.g. four memory arrays or eight memory arrays, it is possible to increase the read-out voltage and to raise the writing speed. Since, however, one Y decoder needs to be provided for every two memory arrays and one set of common input/output lines are one sense amplifier needs to be provided for every memory array, these peripheral circuits necessitate a large area being provided which is disadvantageous.

A semiconductor memory is disclosed in United States Specification No. 4,056,811. It specifically relates to random access memories. The memory cells in a row are divided into sub-rows and an access transistor is used to selectively isolate or connect the output terminals of each sub-row of the memory cells to the row line. The capacitive loading of the output signal from the memory cells is reduced when the data stored therein is recalled. Each row of memory cells is divided into contiguous sub-rows, and a sub-row data conductor is associated with each sub-row of memory cells. Memory cells in the same column are connected to a common word line. Access devices are provided, each of which is connected to the corresponding sub-row conductor, so that all access devices in the same row can be controlled by a single line. The access devices in the same row connect the sublines to a common row conductor. Thus, when the data stored in a memory cell has to be recalled, which cell is in a particular sub-row, the access devices belonging to the other sub-row remain turned off, so that only the output terminals of the memory cells in said particular sub-row are connected to the common row line. For a memory array of a given size, the advantage of dividing each row of memory cells into sub-rows rather than decreasing the number of memory cells per row and increasing the number of rows in the array, is that the former requires less semiconductor surfaces area per stored bit than does the latter. Because each row line requires a separate sense amplifier, and row line decoder, while each column line requires only a column line decoder, a configuration which has a decreased number of memory cells per row and an increased number of rows would require more area for the support circuitry.

Another semiconductor memory device is disclosed in US-A-436559 and DE-A-2919166. The memory device comprises a plurality of pairs of digit lines, a plurality of sense amplifiers, each having a pair of input terminals, a plurality of pairs of gating means and a plurality of memory cells. In this construction, respective pairs of input terminals of the sense amplifier are operatively coupled through respective pairs of gating means to respective pairs of digit lines, whereby a load chapcitance of a digit line is reduced in order to increase the detection sensitivity and thus provide high speed operation.

The present invention seeks to provide a semiconductor memory having large storage capacity without a substantial increase in the area needed for the peripheral circuits, and which is capable of fast writing and fast reading and which exhibits a high S/N ratio and a high reliability. According to the present invention there is provided: a memory device including:

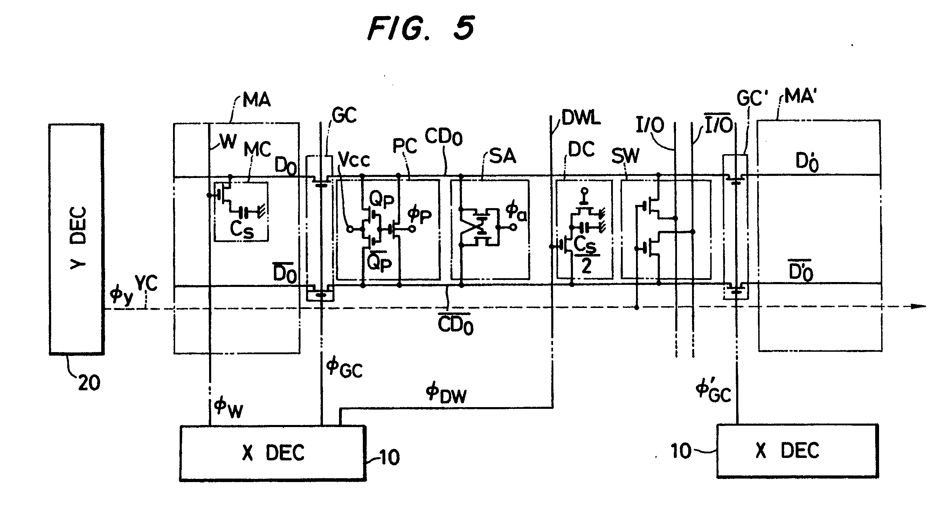

(a) a plurality of sub-arrays (MA, MA', - -) each having a plurality of word lines (W), a plurality of data lines (D) which extend in a direction intersecting with said plurality of word lines and a plurality of memory cells (MC); each said memory cell (MC) being located at the point of intersection between a word line (W) and one of a pair ($D_{oo}$,;$D_{oo}$; $D_{oo}'$, $D_{oo}'$ - -) of said data lines, and includes a capacitor (Cs) for storing a signal, and a transistor (Q) to connecct the capacitor (Cs) to a corresponding data line (D), the data lines being formed in a folded data line structure to be coupled to said memory cells (MC); and the pairs of data lines being provided with differential signals, respectively arranged in proximity to each other in parallel and connected to respective differential amplifiers (SA), each differential amplifier being arranged in common to two pairs of data lines and located between the corresponding memory sub-arrays;
(b) a plurality of common lines (I/O(0), I/O(1), - -) each of the common lines being arranged in common with at least two pairs of corresponding data lines (D) two of said plurality of common lines corresponding to said pairs of data lines forming a pair of common lines (I/O, I/O(0),....);
(c) a plurality of means (SW, GC, GC') for connecting said two pairs of corresponding data lines (D) to said common lines;
(d) a plurality of control lines (YC) each of which controls at least a corresponding one of said connecting means (SW) to control the connection of said data lines to said common lines;
(e) a first decoder for selecting at least one of said plurality of word lines (W); and
(f) a second decoder for controlling the selection of rows of pairs of data lines by the control lines (YC);
wherein:
    (i) each of the common lines (I/O(0), I/O(1), ...) is located between the corresponding memory sub-arrays;
    (ii) each of said connecting means (SW, GC, GC') connects two pairs of corresponding data lines to a corresponding common line, each connecting means (SW,GC, GC') comprising means provided in common for two pairs of corresponding divided data lines belonging to different sub-arrays for selectively connecting one pair of both pairs of data lines to a corresponding common line;
    (iii) at least four of said sub-arrays (MA, MA', - -) are arranged on one side of said second decoder, and are arranged in the direction of said control lines (YC), said first and second decoder being arranged along two mutually perpendicular sides of said combination of at least four of said sub arrays;
    (iv) there is driver means comprised with said second decoders for driving the control lines (YC);
    (v) said connecting means (SW) comprises a first switching means (GC, GC') for selecting one pair of the corresponding pairs of data lines for correction to the differential amplifier based on an applied first signal on a first control line, and a second switching means (SW), for connecting a pair of data lines selected by said first switching means to a corresponding common line based on a signal on a corresponding control line;
    (vi) each said differential amplifier (SA) includes means for differentially amplifying two signals on two the selected pair of said data lines which two data lines are selected by two respectively corresponding first switching means (GC, GC') wherein two of said first switching means coupled to two of said four data lines are supplied in common with said first signal, with said two of said first switching means coupled to the other two of said four data lines being supplied in common with a signal complementary to said first signal when either two or said four data lines are selected; and
    (vii) said memory device further comprises a plurality of precharge circuits (PC, Fig. 5) for pre-charging said two pairs of data lines.

In accordance with such constructions, the sub lines onto which the data of the memory cells are once read out can have their capacitances reduced owing to the division in the lengthwise direction, so that a reading operation of high speed and high gain is permitted. In addition, even when the number of divisions is increased one decoder for addressing in the digit direction (Y decoder) suffices, so that substantially no increase in the area occupied by the peripheral circuits results. In accordance with this construction, either the control lines or the common input/output lines need to be laid in the same direction as that of the divided data lines and across the memory array. However, since such wiring can be provided in a multi-level fashion by forming it as a layer different from that of the data lines (sub lines), the area occupied by the memory array is not substantially increased.

The present invention will now be described in greater detail by way of example with reference to the remaining figures of the accompanying drawings, wherein:-

Figure 2 is a circuit diagram illustrating the structure of a memory array which is common to several embodiments of the present invention;

Figure 3 is a detailed circuit diagram of a first preferred form of memory array in a semiconductor memory;

Figures 4A, 4B and 4C are a plan view, an equivalent circuit diagram and a sectional view of a memory cell of the memory array shown in Figure 3;

Figure 5 is a circuit diagram showing a part of the memory array shown in Figure 3 in greater detail;

Figure 6 is a waveform diagram illustrating the operation showing operations in the circuit shown in Figure 5;

Figures 7 and 8 are respectively a circuit diagram showing a part of the circuit shown in Figure 5 in greater detail and a waveform diagram illustrating the operation thereof;

Figure 9 is a plan view of a chip for the memory array shown in Figure 3;

Figure 10 is a plan view showing another chip; and

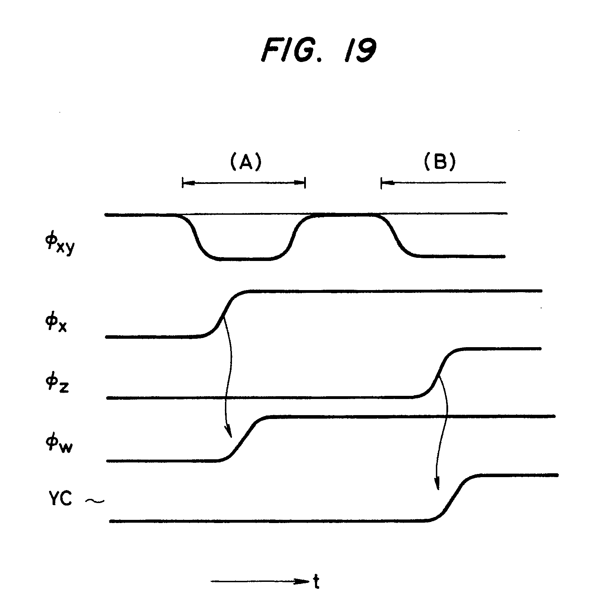

Figures 11 to 24 are circuit diagrams and waveform diagrams showing other embodiments and illustrating the operation thereof.

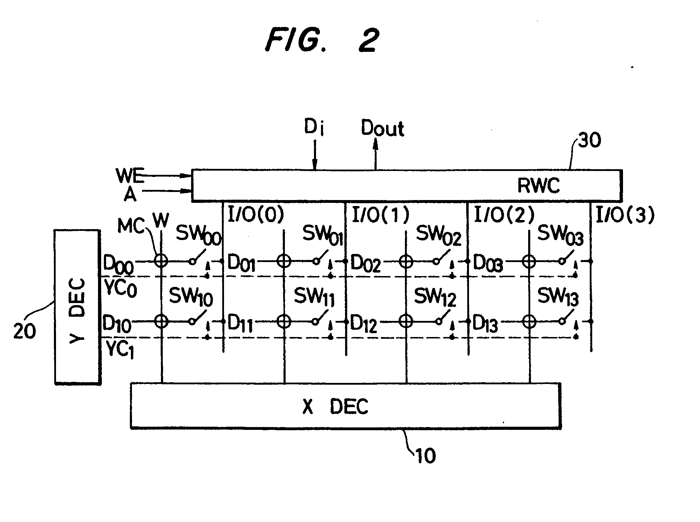

Figure 2 conceptually shows a structure which is common to several embodiments of the present invention. In a memory wherein word lines W and data lines $D_{ij}$ are arranged into a matrix to form a memory array, each data line is divided into, e.g. $D_{00}$, $D_{01}$, $D_{02}$ and $D_{03}$ as shown in the figure. In parts of the respective divided data lines, there are arranged switches $SW_{00}$, $SW_{01}$, $SW_{02}$ and $SW_{03}$ which are controlled by an output control signal $YC_0$ provided from a circuit block 20 including a Y decoder and a Y driver. Data are exchanged through these switches between the respective data lines and common input/output lines I/O(0), I/O(1), I/O(2) and I/O(3) which are common to other divided data lines (for example $D_{10}$). As a result, data are written into or read out from memory cells MC by a read/write controller 30.

With such a construction, the data lines are divided, so that a read-out signal of high output voltage is obtained from the memory cell MC to the data line $D_{00}$ at high speed by a word selection voltage which is delivered to the selected word line W from a circuit block 10 including an X decoder and a word driver. Moreover, with this construction, no substantial increase in the chip area resulting from the division occurs. The reason is that the circuit block 20 does not have to be duplicated for each divided memory array, so that it is sufficient to provide only one circuit block 20 common to the sub data lines.

In the construction shown in Figure 2, when lines YC are formed by a manufacturing step different from that of the lines $D_{ij}$, multi-level wiring becomes possible, and hence, the area of the memory array does not increase. By way of example, it is considered that the word lines W are formed of polycrystalline Si or a metal such as Mo, that the principal parts of the data lines are formed of a first layer of Al, and that the control lines YC are formed of a second layer of Al. It is also considered to form the word lines W out of a first layer of Al, the principal parts of the data lines $D_{ij}$ out of a polycrystalline Si or diffused layer, and the control lines YC out of a second layer of Al.

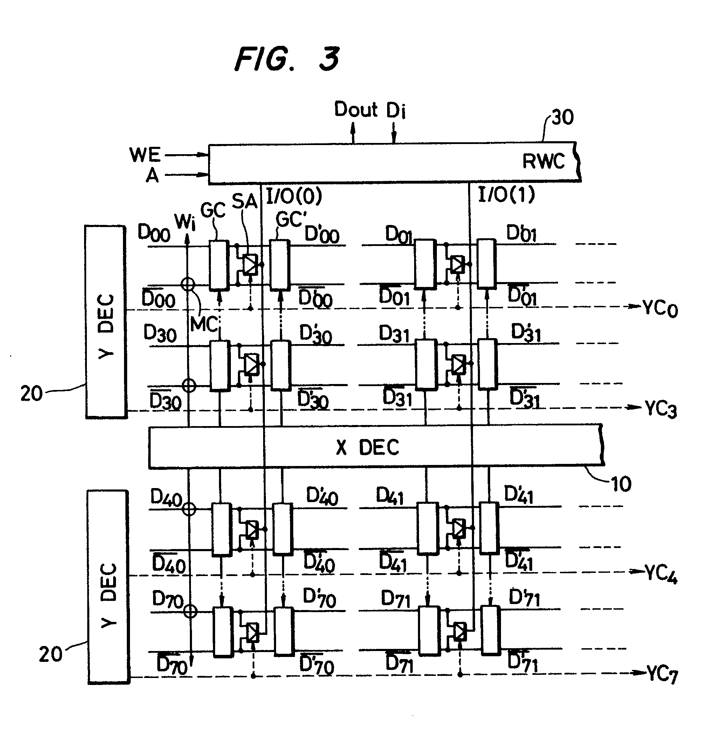

Figure 3 shows a preferred form of memory array as applied to a semiconductor memory having a folded data line arrangement.

A data line forming each row is divided into, e.g. $D_{00}$, $D_{00}'$, $D_{01}$ and $D_{01}'$. The pair of data lines $D_{00}$ and $\overline{D_{00}}$ are connected to a sense amplifier SA through a switching circuit GC. The pair of data lines $D_{00}'$ and $\overline{D_{00}'}$ are connected to the sense amplifier SA through a switching circuit GC'. Accordingly, the sense amplifier SA is arranged in common to the data pair lines $D_{ij}$, $\overline{D_{ij}}$ and the other data pair lines $D_{ij}'$, $\overline{D_{ij}'}$. A single control line $YC_0$ is arranged in correspondence with data lines $D_{00}$, $D_{00}'$, $D_{01}$, $D_{01}'$ ...aligned in one row and data lines $\overline{D_{00}}$, $\overline{D_{00}'}$, $\overline{D_{01}}$, $\overline{D_{01}'}$ ... paired therewith. Control lines $YC_3$, $YC_4$, $YC_7$ etc. are respectively arranged in correspondence with other data pair lines.

Word lines (only one word line $W_i$ being illustrated in Figure 3) intersecting the data lines are selectively driven by a circuit block 10 which includes an X decoder and a word driver. Only one of the switching circuits GC and GC' is driven by a control signal $\emptyset_{GC}$ or $\emptyset_{GC}'$ from the circuit block 10. The information of only one of the memory cells connected with the data lines $D_{00}$, $D_{00}'$, $\overline{D_{00}}$ and $\overline{D_{00}'}$ is transmitted to one end of the sense amplifier SA. The information of a dummy cell, not shown, is transmitted to the other end of the sense amplifier SA. Signals are similarly transmitted to other sense amplifiers, and each sense amplifier differentially amplifies the transmitted signals.

All outputs from the sense amplifiers arrayed in the first column are associated with a common input/output line I/O(0). Among these sense amplifiers, only one selected by the circuit block 20 through any of the control lines $YC_0$, $YC_3$, $YC_4$, $YC_7$ etc. has its output applied to the common input/output line I/O(0) and then transmitted to a read/write controller 30. Likewise, the outputs of the sense amplifiers arrayed in the other columns are transmitted to selected common input/output lines I/O(1) etc. The read/write controller 30 is controlled by an address signal A and a write/read control signal WE, and provides a data output $D_{out}$ corresponding to the potential of the desired one of the common input/output lines. A writing operation is similarly performed in such a way that a data input $D_i$ supplied from outside the chip is applied to the selected common input/output line and then to the selected memory cell.

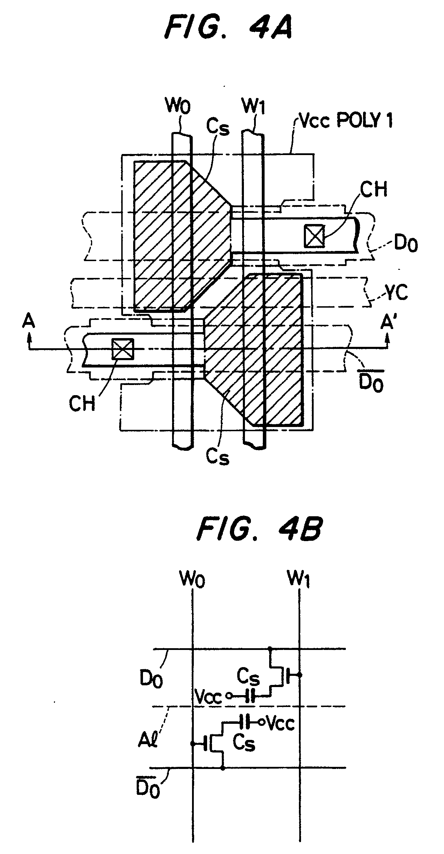

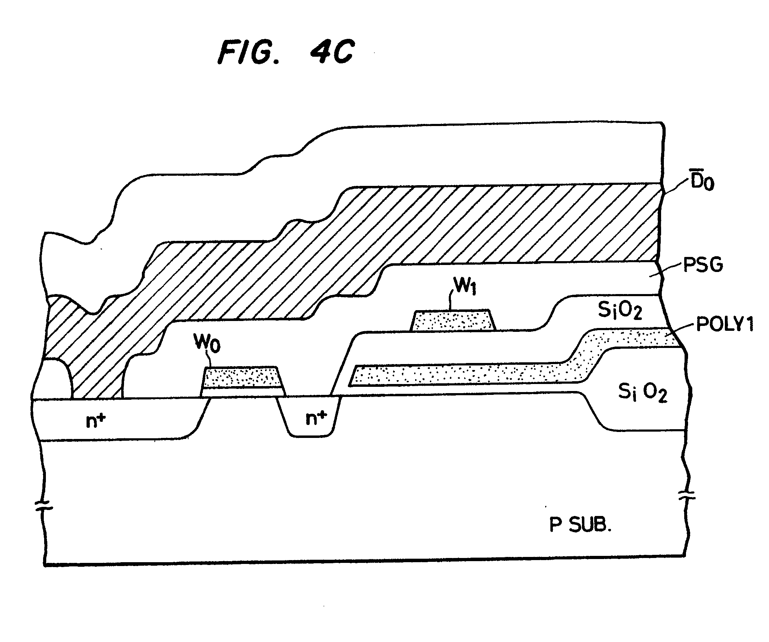

Referring now to Figures 4A, 4B and 4C as seen from the equivalent circuit diagram of Figure 4B, the plan view of Figure 4A shows only the portion of two memory cells which are respectively connected to the paired data lines $D_0$ and $\overline{D_0}$. The part enclosed with a dot-and-dash line indicates a first layer of polycrystalline silicon POLY I to which a supply voltage $V_{CC}$ is applied. In the part POLY I, hatched areas are parts which are formed on a silicon diode layer thinner than in the other part, and storage capacitances $C_S$ are formed by the hatched parts and a silicon substrate. The word lines $W_0$ and $W_1$ are formed of a second layer of polycrystalline silicon, and parts of them form the gates of MOS transistors. These layers are overlaid with a phosphosilicate glass layer PSG, on which the data lines $D_0$ and $\overline{D_0}$ indicated by broken lines and formed of a first layer of aluminium are formed. A contact area CH is provided for the connection between the aluminium layer and an $n^+$-type diffused layer in the silicon substrate. The first layer of aluminium is overlaid with an inter-layer insulating film, on which the control line YC made of a second layer of aluminium is formed.

As shown in Figure 4A, the control line YC which is laid between the pair of data lines $D_0$ and $\overline{D_0}$ should desirably be arranged in the middle of these data lines. The reason is that when the control line YC is located nearer to either data line, the data lines $D_0$ and $\overline{D_0}$ come to have unequal capacitances with respect to the control line YC, which gives rise to the generation of noise in the differential reading of signals on the data lines $D_0$ and $\overline{D_0}$.

Figure 5 shows the sense amplifier SA in greater detail and the proximate circuits which have been omitted from Figure 3.

The data lines $D_0$ and $\overline{D_0}$ are connected to nodes $CD_0$ and $\overline{CD_0}$ through the switching circuit GC. The data lines $D_0'$ and $\overline{D_0'}$ are also connected to the nodes $CD_0$ and $\overline{CD_0}$ through the switching circuit GC'. The nodes $CD_0$ and $\overline{CD_0}$ have a precharging circuit PC, the dummy cell DC and a switching circuit SW connected thereto in addition to the sense amplifier SA.

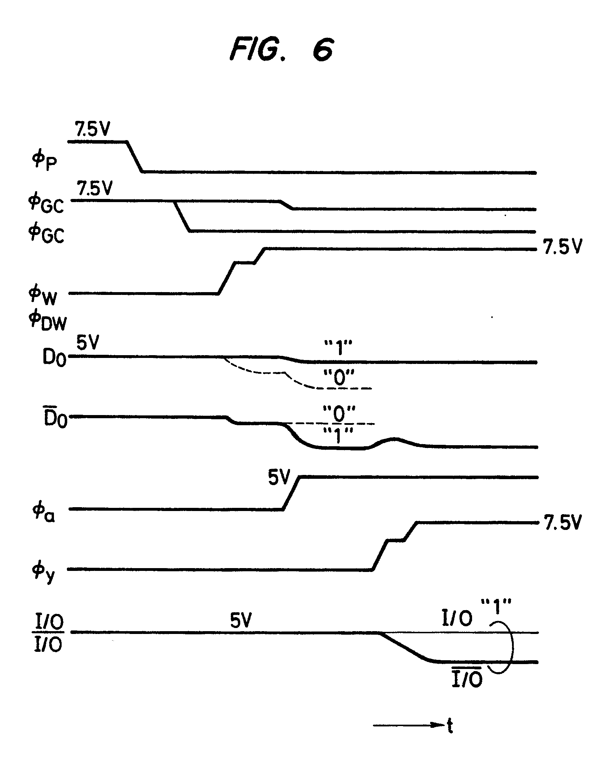

The operation of the above embodiment will be described in greater detail with reference to the waveforms shown in Figure 6. First, all of the nodes ($D_0$, $\overline{D_0}$, $CD_0$, $\overline{CD_0}$, $D_0'$, $\overline{D_0'}$ etc.) are precharged to a high potential by a precharge signal $\varnothing_p$, whereupon the word line W is selected by a word pulse $\varnothing_W$ provided from the X decoder. Then, all the memory cells connected to the word line are selected. By way of example, a minute signal voltage which is determined by the storage capacitance $C_S$ of the memory cell MC and the capacitance of the data line $D_0$ is delivered to this data line $D_0$ corresponding to the memory cell MC. At the same time, a reference voltage is delivered from the dummy cell DC to the node $CD_0$ by

turning "on" a pulse $\varnothing_{DW}$. Before the word line is selected, the switching circuit GC' connected to the data line to which the memory cell to be selected does not belong is turned "off" in such a way that a control signal $\varnothing_{GC}'$ is brought from the high level at the precharging into a low level. In contrast, the switching circuit GC remains "on". Accordingly, signal voltages corresponding to an information from the memory cell MC appear at $D_0$ and $CD_0$, and the reference voltage from the dummy cell DC appears at $\overline{D_0}$ and $\overline{CD_0}$. Since the capacitance of the dummy cell DC is selected to be one half that of the storage capacitance $C_S$ of the memory cell MC, the reference voltage is set to be intermediate between the read-out voltages which appear at $D_0$ and $CD_0$ in correspondence with the information "1" and "0" of the memory cell MC. At the input terminals of the sense amplifier SA, therefore, minute fluctuating voltages corresponding to the information "1" and "0" appear at all times. Thereafter, the sense amplifier SA is operated by a start pulse $\varnothing_a$ so as to amplify the differential voltages. Thereafter, a control signal $\varnothing_y$ is delivered to the control line YC selected by the Y decoder Y DEC, and the amplified differential voltages are differentially applied onto the pair of common input/output lines I/O and $\overline{I/O}$ via the switch SW.

Important features of the above described circuit arrangement are:-

(a) that the common input/output lines are located between the memory arrays MA and MA' not on one side of each memory array, so the reading and writing operations can be performed fast, and

(b) that since the precharging circuit PC and the dummy cell DC are made common to the two memory arrays MA and MA' the required area decreases accordingly.

Of course, these circuits can be arranged for the respective memory arrays MA and MA' as in the prior art without being made common. In Figure 6, the supply voltage $V_{CC}$ = 5 volts by way of example, and the signals $\varnothing_P$, $\varnothing_{GC}$ and $\varnothing_{GC}'$ are set at 7.5 volts in order to apply a sufficiently high voltage so that the data lines $D_0$ and $\overline{D_0}$ may be precharged with equal voltages. The signals $\varnothing_W$ and $\varnothing_{DW}$ are set at 7.5 volts in order to make the read-out voltage from the memory cell high by boosting the word line to 7.5 volts with a capacitor. The signal $\varnothing_y$ is set at 7.5 volts in order to raise the mutual conductances $g_m$ of the MOS transistors within the switching circuit SW so that the signals may be delivered from the nodes $CD_0$ to $\overline{CD_0}$ to the common input/output lines I/O and $\overline{I/O}$ at high speed.

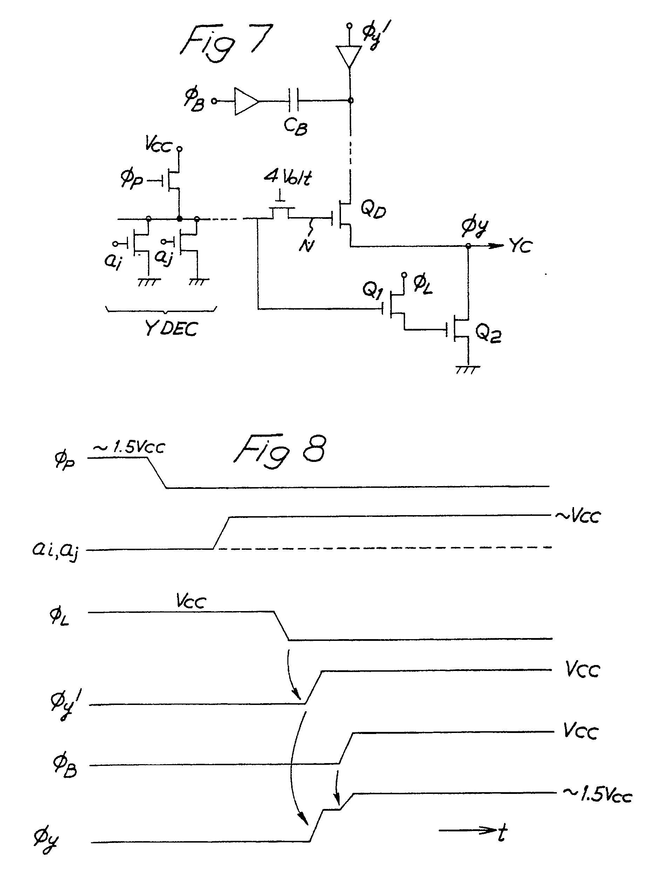

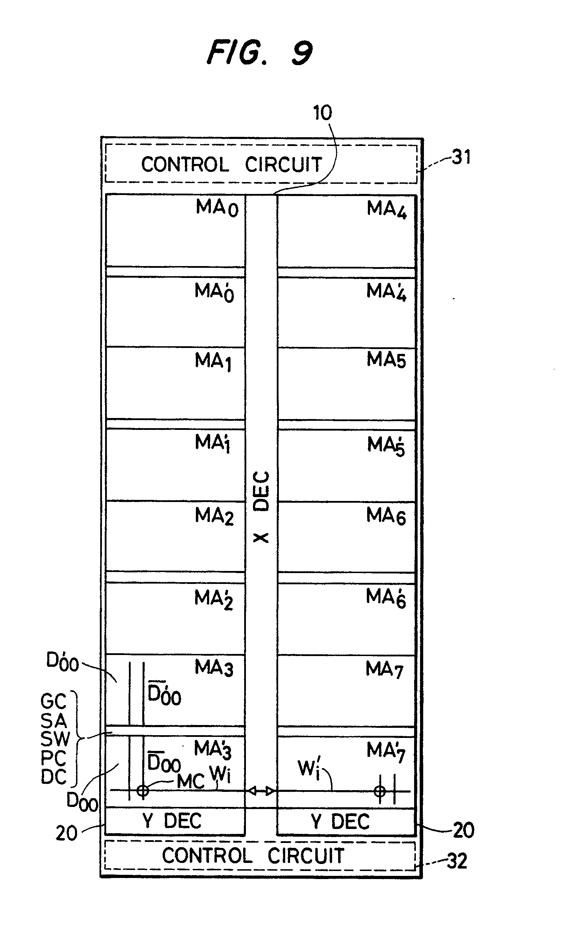

That portion in the circuit block 20 which pro-duces the control signal $\varnothing_y$ boosted to 7.5 volts with respect to the supply voltage $V_{CC}$ of 5 volts is illustrated in Figure 7, whilst waveforms in various parts of the portion are shown in Figure 8.

When the Y decoder Y DEC precharged to the supply voltage $V_{CC}$ by the signal $\emptyset_P$ has been selected, decoding MOS transistors remain in the "off" states, and a node N remains at the high level, so that a MOS transistor $Q_D$ holds the "on" state. Under this condition, a pulse $\emptyset_y{}'$ indicative of the timing of the generation of the control signal $\emptyset_y$ is provided and applied to the control line YC through the MOS transistor $Q_D$. A boosting signal $\emptyset_B$ is subsequently applied through a capacitance $C_B$, whereby the voltage of the control line YC is boosted to produce a waveform as shown by the signal $\emptyset_y$. MOS transistors $Q_1$ and $Q_2$ constitute a circuit which keeps the control line YC connected to earth potential with a low impedance when this control line is non-selected, in order to prevent the potential of the non-selected control line from rising due to any unnecessary coupled voltage.

Referring now to Figure 9, the chip is in the shape of an elongated rectangle so that it may be readily received in a standard DIP (Dual In-Line Package). The direction of the divided data lines $D_{00}$, $D_{00}{}'$ etc. agrees with the lengthwise direction of the chip. The circuit block 10 including the X decoder is arranged centrally of the chip, and on both the sides thereof, the memory arrays $MA_0$, $MA_0{}'$, $MA_1$, $MA_1{}'$ etc. divided by the division of the data lines are arranged in alignment. The circuit blocks 20 including the Y decoders are each arranged on one side of the alignment of the memory arrays. The control circuits 31 and 32 are arranged in the remaining parts.

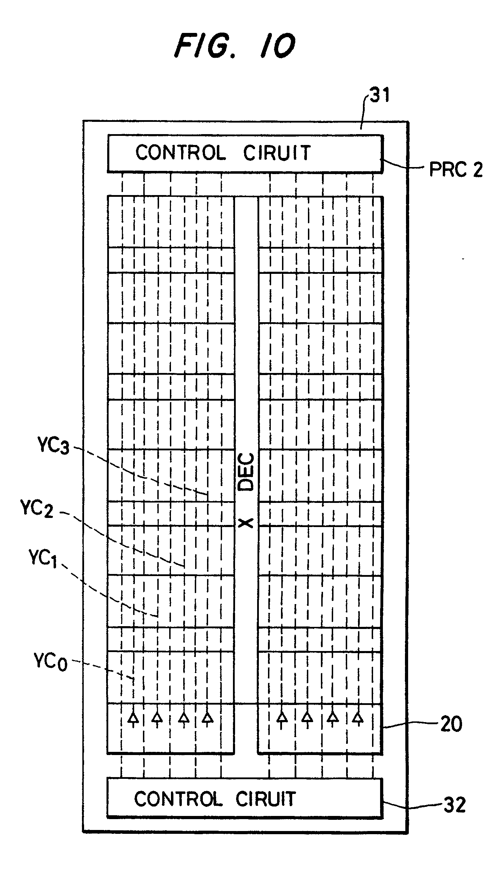

The control lines YC are laid from the circuit blocks 20 including the Y decoders, so as to extend across the memory cells. In the case where the spacing between the adjacent control lines has room as in embodiments to be described later, different wiring lines from the control circuits 31 and 32 can be formed of the same layer as that of the control lines YC as illustrated in Figure 10.

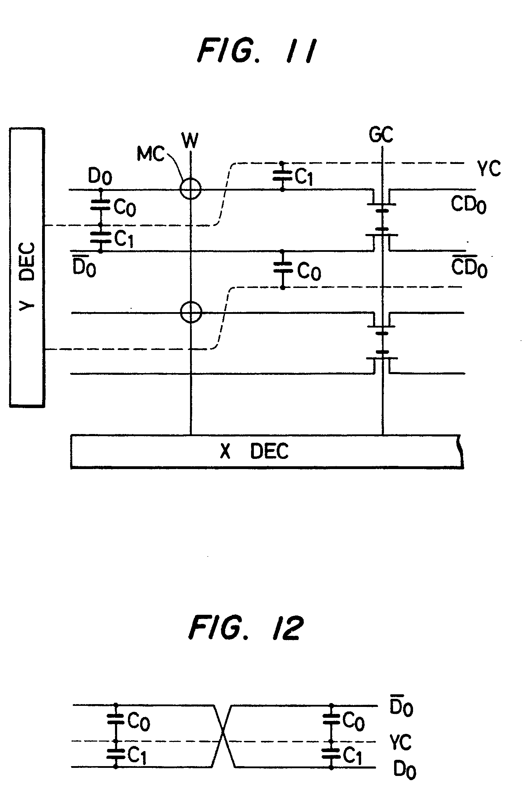

Referring now to a modified embodiment shown in Figure 11, it should be noted from what has been said previously that the control line YC is preferably arranged in the middle of the data lines $D_0$ and $\overline{D_0}$ in order to avoid the difference of the capacitances of these data lines. In this regard, however, the control line YC and the data lines $D_0$, $\overline{D_0}$ are formed of different layers. Therefore, the misregistration of masks involved in manufacturing steps incurs unequal capacitances of the lines $D_0$ and $\overline{D_0}$, which form a noise source.

As shown in Figure 11, therefore, the control lines YC are formed so as to intersect over the middle parts of the divided data lines $D_0$ etc. According to such a construction, even when the mask misregistration has occurred in the manufacturing steps, both the data lines $D_0$ and $\overline{D_0}$ can have equal capacitances of $(C_0 + C_1)$.

It is possible to realize various other structures in which even in the presence of the mask misregistration, no difference occurs between the capacitances of the paired data lines as described above. Figure 12 shows an example in which the data line $D_0$ and $\overline{D_0}$ intersect each other in their middle parts.

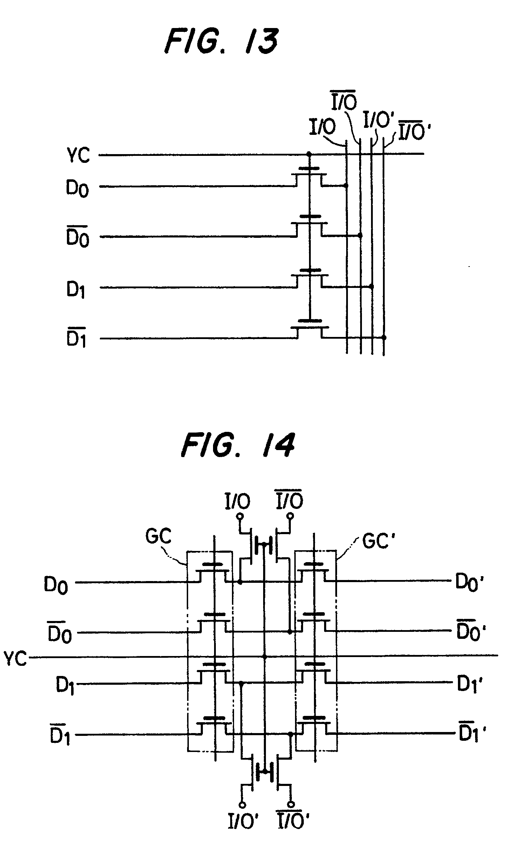

In any of the foregoing embodiments, one control line is arranged in correspondence with the paired data lines. In order to reduce the number of control lines, a construction in which one control line is arranged for two pairs of data lines is also realisable. Figure 13 shows the general circuit arrangement of such an embodiment, whilst Figure 14 shows an embodiment in the case where the switching circuits GC and GC' as shown in Figure 3 are jointly used.

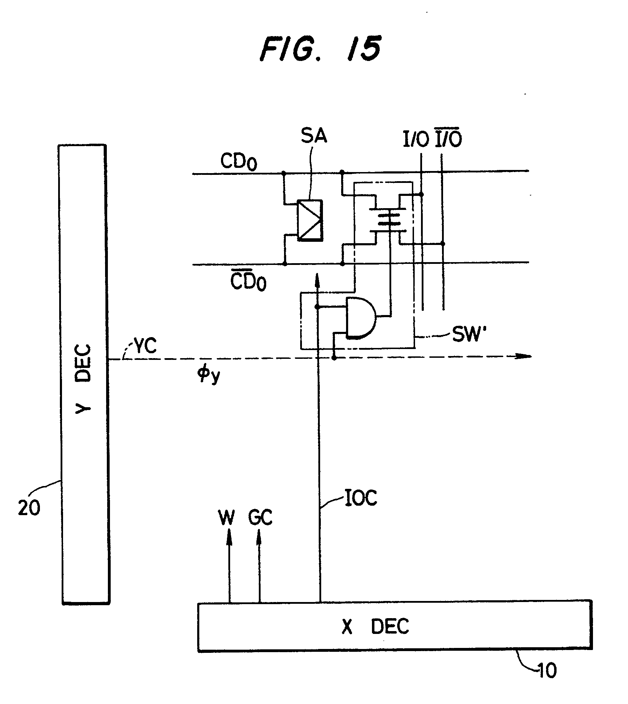

Figure 15 shows an embodiment in which the portion of the switching circuit SW in the embodiment shown in Figure 5 is modified. The modified switching circuit SW' is controlled by the control line YC and a control line IOC extending from the X decoder 10. Since only the switching circuit SW' existing at the intersection point of the selected lines X and Y turns "on", outputs can be selectively delivered to the lines I/O(O), I/O(1) etc. in Figure 3. This signifies that the lines I/O(O), I/O(1) etc. can be decoded in advance. Therefore, a simplified circuit can be adopted for the read/write controller 30.

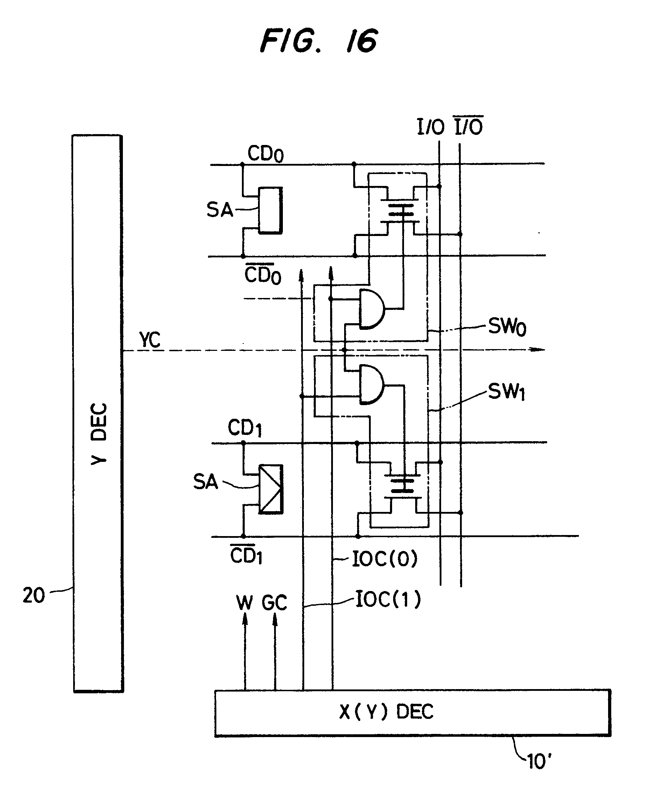

Figure 16 shows an example in which, by expanding the idea of the embodiment shown in Figure 15, the control line YC is arranged in correspondence with two pairs of data lines, not each pair of data lines. Thus, the number of wired control lines YC becomes half, that is, the wiring pitch is twice as great as the previous embodiments, so that the manufacture is facilitated. In operation, the switching circuit $SW_0$ or $SW_1$ turns "on" only when the signal from the control line IOC(O) or IOC(1) and the signal from the control line YC have coincided. However the embodiment shown in Figure 16, differs from the embodiment shown in Figure 15 in that the signal of the control line IOC(O) or IOC(1) includes an information of a Y-system address signal besides that of an X-system address signal. That is, when the pair of the data lines $D_0$ and $\overline{D_0}$ is selected, the line IOC(O) is selected by the X(Y) decoder 10', and when the pair of the data lines $D_1$ and $\overline{D_1}$ is selected, the line IOC(1) is selected (usually a signal "1" is provided). Needless to say, the above referred to X- and Y-system address signals simply signify X and Y in the arrangement of two-dimensional points in a plane, and they should be discriminated from the logic addresses of the memory.

Whilst the control line YC is arranged in correspondence with the two pairs of data lines, it is needless to say that each control line YC can be arranged in correspondence with any desired number of pairs of data lines.

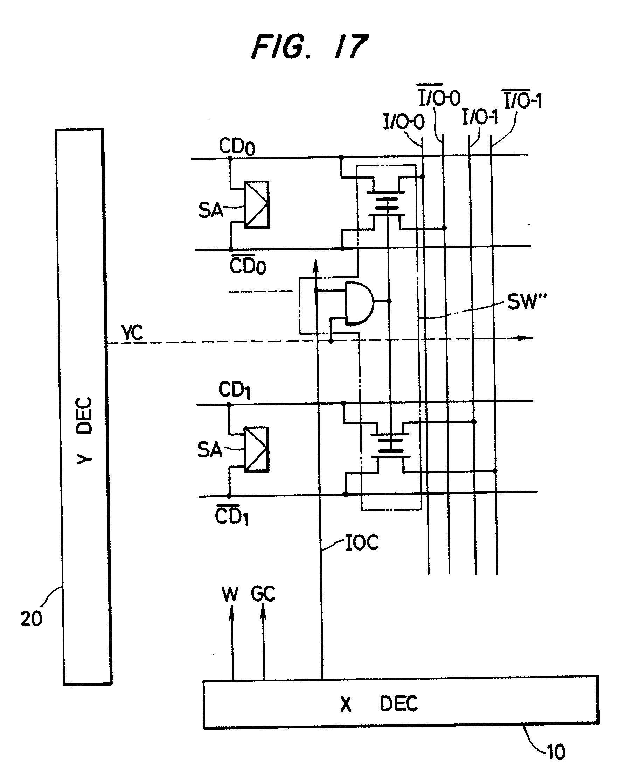

Figure 17 shows another embodiment in which the wiring pitch of the lines YC is enlarged, for example, twice as great as in the case of Figure 16. Two sets of I/O lines are provided, and the lines I/O-O and $\overline{I/O\text{-}O}$ are connected to the lines $CD_0$ and $\overline{CD_0}$ and the lines I/O-1 and $\overline{I/O\text{-}1}$ to the lines $CD_1$ and $\overline{CD_1}$ by a switching circuit SW", respectively, so as to exchange signals with the exterior. The two sets of I/O lines have either selected and connected with the line $D_i$ or $D_{out}$ by the read/write controller 30 shown in Figure 2. Alternatively, it is possible to provide a plurality of lines $D_i$ or $D_{out}$ and to directly connect the I/O lines therewith without performing the selecting operation.

With the present embodiment, as in the embodiment of Figure 16, the wiring pitch of the control lines YC can be enlarged thus facilitating the manufacture.

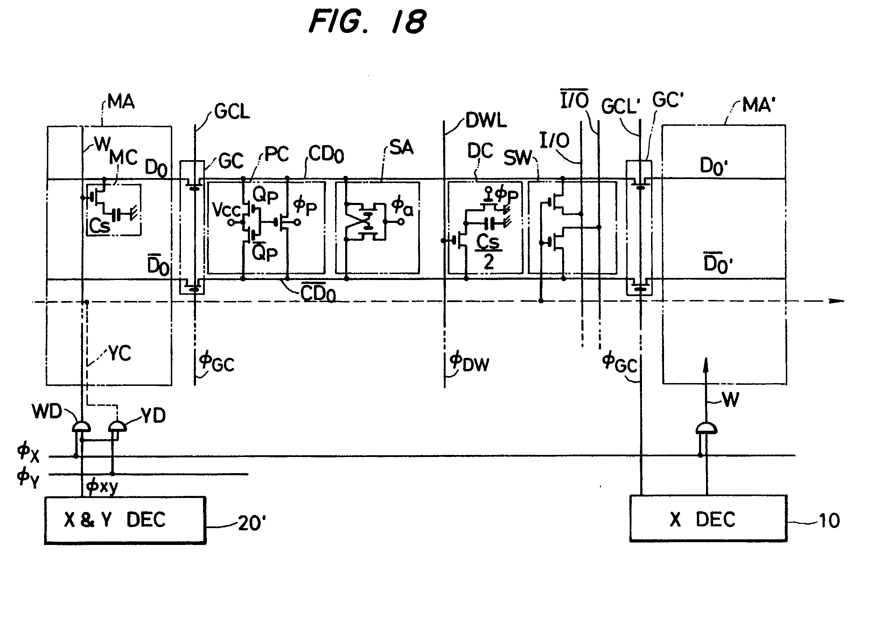

Whilst the embodiments thus far described are based on the structure of Figure 3, it is obvious that the X and Y decoders can be arranged in proximity as shown in Figure 18. In the embodiment shown in Figure 5, the Y decoder 20 is replaced with an X and Y decoder 20'. The X and Y decoder 20' carries out the operation (A) of an X decoder and the operation (B) of a Y decoder in divided time zones. The coincidence between a pulse $\emptyset_{xy}$ and a pulse $\emptyset_x$ or $\emptyset_y$ is taken by a gate circuit WD or Yd so as to form the output of the word line W or the control line YC. The gate circuits WD and YD are similar in arrangement to the circuit shown in Figure 7. Therefore, they are not described in detail.

In Figure 18, the circuit block 10 shown in the right-hand part of the drawing does not include the function of the Y decoder. This is based on the assumption that the number of decoders required for driving the control lines YC is within the number of decoders located in the left-hand part of the drawing, and the same function as that of the left decoders is sometimes given to the right decoders 10. In the case where the juxtaposition of the gate circuits WD and YD is difficult in relation to the occupying area, the gate circuit YD can be designed in a manner to be distributed among a plurality of decoder portions.

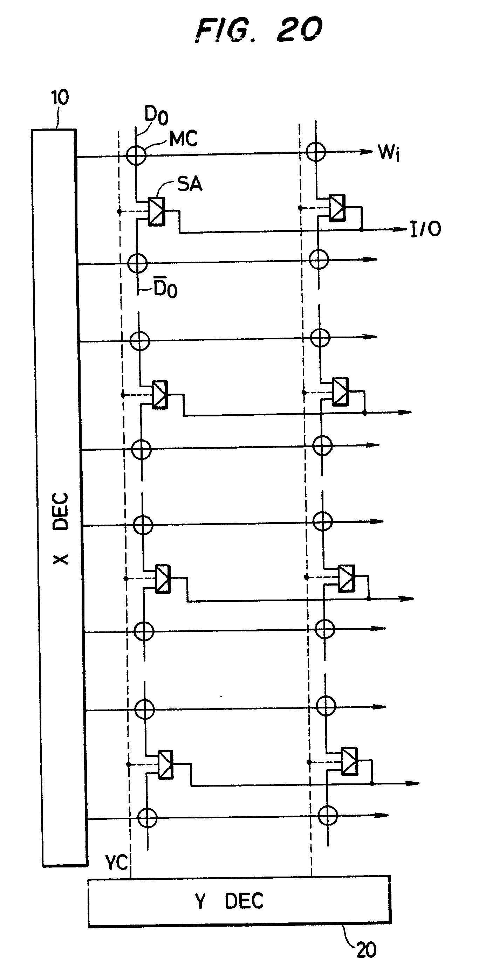

Whereas the above described embodiments are directed to the memory of the folded data line arrangement, an embodiment shown in Figure 20 is directed to a memory of the open data line arrangement. Also in this embodiment each data line is divided into a plurality of sub lines in the lengthwise direction. This arrangement is different from the embodiment shown in Figure 3 in that the paired data lines $D_0$ and $\overline{D_0}$ are arranged rectilinearly. In the embodiment of Figure 3, polycrystalline silicon being a wiring material of comparatively high resistivity is used for the word lines and the word line delay time therefore poses a problem, so that in order to make the time as short as possible, the word lines are divided to arrange the circuit block 10, including the X decoder and driver, in the central position of the divided lines as illustrated in Figure 3. In contrast, in the embodiment shown in Figure 20, she word lines are formed of Al exhibiting a low resistivity, so that the word lines need not be divided and that the circuit block 10 is arranged at one end. Thus, one driver may be located on one side, and hence, the area of the circuit block 10 can be made small.

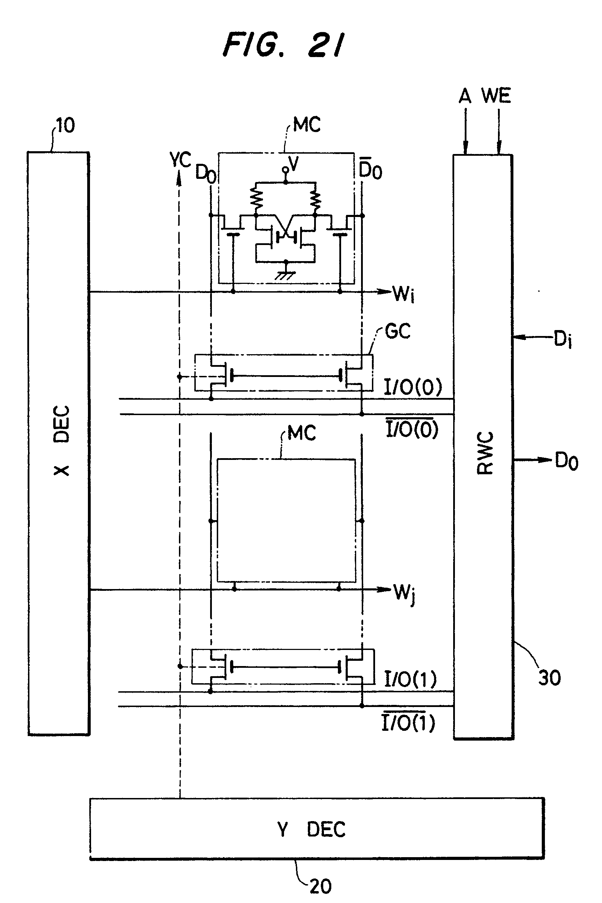

Figure 21 shows an embodiment which is applied to a MOS static memory. When compared with the embodiments of the MOS dynamic memory shown in detail in Figure 5, the embodiment of Figure 21 differs in the structure of the memory cell MC and also differs in that the auxiliary circuits such as the sense amplifiers are not required for the respective pairs of data lines. The paired data lines $D_0$, $\overline{D_0}$, the common input/output lines I/O, $\overline{I/O}$, the control line YC, the switching circuit GC, etc. may be constructed similarly to those shown in Figure 5, and are not described in detail.

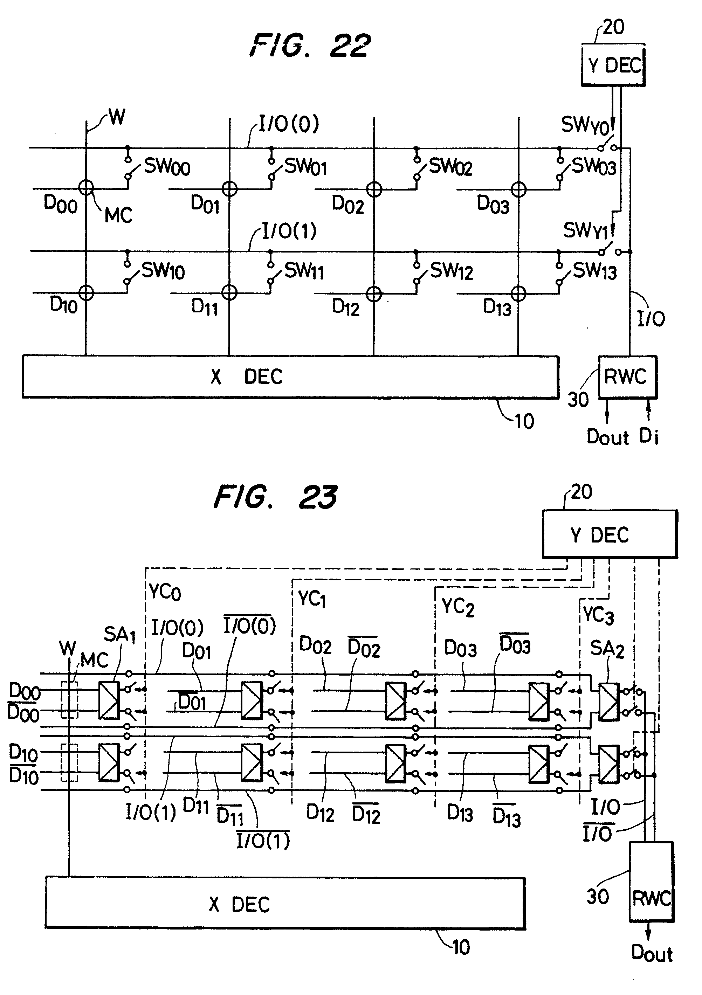

Figure 22 shows the construction of an embodiment in which the sense of the common input/output line common to a plurality of divided data lines is different from that shown in the previous embodiments.

That is, the common input/output line I/O(O) which is common to the divided data lines $D_{00}$, $D_{01}$, $D_{02}$ and $D_{03}$ is arranged in parallel with these data lines.

Figure 23 illustrates an embodiment to which the structure of Figure 22 is applied.

A sense amplifier $SA_1$ of a first stage is connected to the paired divided data lines $D_{00}$ and $\overline{D_{00}}$. Sense amplifiers of the first stage are respectively connected to the other paired divided data lines.

Paired common input/output lines I/O(O) and $\overline{I/O(O)}$ are arranged in correspondence with the data lines forming a row, and are connected to a sense amplifier $SA_2$ of a second stage. Paired common input/output lines I/O(1) and $\overline{I/O(1)}$ and similarly arranged in correspondence with data lines of another row, and are connected to a sense amplifier of the second stage. Outputs from the sense amplifiers of the first stage arrayed in a first column are connected to the respectively corresponding common input/output lines through switches which are controlled by a control line $YC_0$

located in a direction intersecting the common input/output lines. Outputs from the sense amplifiers arrayed in the other columns are similarly connected to the corresponding common input/output lines through switches which are respectively controlled by control lines $YC_1$, $YC_2$ and $YC_3$. These control lines are selectively driven by the circuit block 20 including the Y decoder. The selection in the digit direction is performed on the output side of the sense amplifiers of the second stage by the Y decoder.

Also in this embodiment, the information of the memory cell MC is once read out onto the divided data line, and it is amplified by the sense amplifier of the first stage and then delivered to the common input/output line. Therefore, even when the charge storage capacity of the memory cell is small, the information can be read out with a sufficient margin.

Since the selective drive of the control lines $YC_0$, $YC_1$, $YC_2$ and $YC_3$ serves to effect the selection in the word direction, it may well be performed by the circuit block 10 including the X decoder.

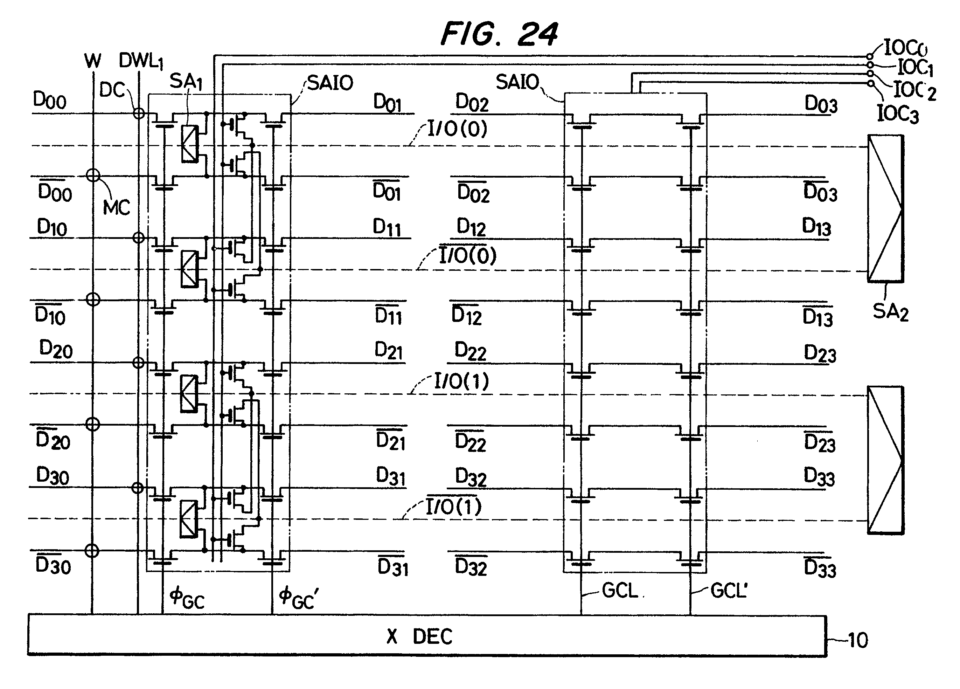

Figure 24 shows another embodiment to which the construction of Figure 22 is applied. The difference between the embodiment shown in this Figure from the embodiment shown in Figure 23 is that the paired common input/output lines I/O(O) and $\overline{I/O(O)}$ are arranged in common to two pairs of data line columns. Also control lines for controlling the switching circuits pair as $IOC_0$ and $IOC_1$, or $IOC_2$ and $IOC_3$, and by driving either, one of the two pairs of data line columns is selected. Also the sense amplifiers $SA_1$ of the first stage is arranged in common to the data line pair $D_{00}$, $\overline{D_{00}}$ and the data line pair $D_{01}$, $\overline{D_{01}}$, either of which is selected by the switching circuit which is controlled by control signals $\emptyset_{GC}$ and $\emptyset_{GC}'$ from the circuit block 10 including the X decoder.

## Claims

1. A semiconductor memory device including:

(a) a plurality of sub-arrays (MA, MA', - -) each having a plurality of word lines (W), a plurality of data lines (D) which extend in a direction intersecting with said plurality of word lines and a plurality of memory cells (MC); each said memory cell (MC) being located at the point of intersection between a word line (W) and one of a pair ($\overline{D_{00}}$,;$D_{00}$; $D_{00}'$, $\overline{D_{00}}'$ - -) of said data lines, and includes a capacitor (Cs) for storing a signal, and a transistor (Q) to connect the capacitor (Cs) to a corresponding data line (D), the data lines being formed in a folded data line structure to be coupled to said memory cells (MC); and the pairs of data lines being provided with differential signals, respectively arranged in proximity to each other in parallel and connected to respective differential amplifiers (SA), each differential amplifier being arranged in common to two pairs of data lines and located between the corresponding memory sub-arrays;

(b) a plurality of common lines (I/O(0), I/O-(1), - -) each of the common lines being arranged in common with at least two pairs of corresponding data lines (D) two of said plurality of common lines corresponding to said pairs of data lines forming a pair of common lines (I/O(0) $\overline{I/O}$(1),....);

(c) a plurality of means (SW, GC, GC') for connecting said two pairs of corresponding data lines (D) to said common lines;

(d) a plurality of control lines (YC) each of which controls at least a corresponding one of said connecting means (SW) to control the connection of said data lines to said common lines;

(e) a first decoder (10) for selecting at least one of said plurality of word lines (W); and

(f) a second decoder (20) for controlling the selection of rows of pairs of data lines by the control lines (YC);

characterised in that:

(i) each of the common lines (I/O(0), I/O-(1), ...) is located between the corresponding memory sub-arrays;

(ii) each of said connecting means (SW, GC, GC') connects two pairs of corresponding data lines to a corresponding common line, each connecting means (SW,GC, GC') comprising means provided in common for two pairs of corresponding divided data lines belonging to different sub-arrays for selectively connecting one pair of both pairs of data lines to a corresponding common line;

(iii) at least four of said sub-arrays (MA, MA', - -) are arranged on one side of said second decoder (20), and are arranged in the direction of said control lines (YC), said first and second decoders (10,20) being arranged along two mutually perpendicular sides of said combination of at least four of said sub-arrays;

(iv) there is driver means comprised with said second decoders (20) for driving the control lines (YC);

(v) said connecting means (SW) comprises a first switching means (GC, GC') for selecting one pair of the corresponding pairs of data lines for connection to the differential amplifier based on an ap-

plied first signal ($\emptyset_{GC}$) on a first control line, and a second switching means (SW), for connecting a pair of data lines selected by said first switching means to a corresponding common line based on a signal ($\emptyset_Y$) on a corresponding control line (YC);

(vi) each said differential amplifier (SA) includes means for differentially amplifying two signals on the selected pair of said data lines which two data lines are selected by two respectively corresponding first switching means (GC, GC') wherein two of said first switching means coupled to two of said four data lines are supplied in common with said first signal, with said two of said first switching means coupled to the other two of said four data lines being supplied in common with, a signal complementary to said first signal when either two of said four data lines are selected; and

(vii) said memory device further comprises a plurality of precharge circuits (PC, Fig. 5) for pre-charging said two pairs of data lines.

2. A memory device according to claim 1 wherein said plurality of control lines (YC) are arranged in parallel with said plurality of pairs of data lines.

3. A memory device according to claim 2, wherein principle parts of said plurality of control lines (YC) are formed of a layer different from that of principal parts of said data lines.

4. A memory device according to claim 1, wherein said data lines and said control lines (YC) are both formed of aluminium.

5. A memory device according to claim 2, wherein said control lines (YC) intersect said data lines over the middle parts of said data lines.

6. A memory device according to claim 1, wherein said second decoder (20) comprises a pull-down circuit ($Q_1, Q_2$) for holding non-selected control lines at a low impedance potential.

7. A memory device according to claim 1 further comprising a plurality of dummy cells (DC) each provided in common for two data lines for providing a reference voltage to one of said two data lines which is selected by said first switching means (GC, GC'), one of said first switching means being coupled to one of said two data lines and is supplied with said first signal, and one of said first switching means being coupled to the other of said two data lines and is supplied with a complementary signal to said first signal.

8. A memory device according to claim 1, wherein a plurality of sub-arrays (MA) constituted by said word line (WL), data lines (D) and memory cells (MC) are formed on one chip, and each of said plurality of control lines (YC) is arranged through at least one of said sub-arrays.

9. A memory device according to any one of the preceding claims wherein said second decoder (20) comprises a pull down circuit ($Q_1, Q_2$) for holding non-selected control lines at a predetermined low impedance potential.

10. A semiconductor memory according to any one of the preceding claims, in which the majority of said control lines (YC) are arranged in a layer different from that of said data lines.

11. A semiconductor memory according to any one of the preceding claims wherein said pair of said data lines are arranged in such a manner as to be substantially parallel and to cross one another in at least one portion.

12. A semiconductor memory according to any one of the preceding claims wherein said second decoder (20) has driver means for respectively driving the selected lines.

13. A semiconductor memory according to any one of the preceding claims wherein two of said data lines together constitute a pair of folded bit structure and said common signal lines are also arranged in pairs.

14. A semiconductor memory according to any one of the preceding claims, wherein said second decoder (20) has means ($Q_1$, $Q_2$) acting to fix the non-selected control lines to a non-selection potential.

15. A semiconductor memory according to any one of the preceding claims, wherein means for generating a reference voltage is provided for each of said data lines.

16. A semiconductor memory according to any one of the preceding claims wherein the plurality of precharge circuits (PC, Fig.5) are each provided in common for said two pairs of data lines.

17. A semiconductor memory according to any one of the preceding claims wherein said plurality of data lines and plurality of common lines are arranged parallel to each other.

18. A semiconductor memory according to any one of the claims 1 to 16 wherein said plurality of data lines and plurality of common lines are arranged perpendicular to each other.

19. A semiconductor memory according to any one of the preceding claims wherein said plurality of control lines (YC) are arranged parallel to the direction of the long side of the chip (31).

20. A semiconductor memory according to any one of the preceding claims wherein said plurality of control lines (YC) are arranged in the middle of said pair of plurality of data lines.

**Revendications**

1. Dispositif de mémoire à semiconducteurs comprenant :

(a) une pluralité de sous-ensembles (MA, MA',- -) possédant chacun une pluralité de lignes de transmission de mots(W), une pluralité de lignes de transmission de données (D) s'étendant selon une direction entrecoupant ladite pluralité de lignes de transmission de mots et une pluralité de cellules de mémoire (MC) ; chacune desdites cellules de mémoire (MC) étant disposée au point d'intersection entre une ligne de transmission de mots (W) et l'une d'une paire ($\overline{D_{oo}}$ , $D_{oo}$ ; $D_{oo}$', $\overline{D_{oo}}'$ - -) desdites lignes de transmission de données, et comprenant un condensateur (Cs) pour mémoriser un signal, et un transistor (Q) pour relier le condensateur (Cs) à une ligne de transmission de données (D) correspondante, les lignes de transmission de données étant formées selon une structure de ligne de transmission de données repliée pour être couplées auxdites cellules de mémoire (MC) ; et les paires de lignes de transmission de données recevant des signaux différentiels, respectivement disposées à proximité l'une de l'autre en parallèle et connectées à des amplificateurs différentiels respectifs (SA), chaque amplificateur différentiel étant commun à deux paires de lignes de transmission de données et disposé entre les sous-ensembles de mémoire correspondants ;

(b) une pluralité de lignes communes (I/O(0), I/O(1), - -) chacune des lignes communes étant agencée en commun avec au moins deux paires de lignes de transmission de données correspondantes (D), deux de ladite pluralité de lignes communes correspondant auxdites paires de lignes de transmission de données formant une paire de lignes communes (I/O(0), $\overline{I/O}$(1),...) ;

(c) une pluralité de moyens (SW, GC, GC') pour relier lesdites deux paires de lignes de transmission de données correspondantes (D) auxdites lignes communes ;

(d) une pluralité de lignes de commande (YC), dont chacune commande au moins l'un , correspondant,desdits moyens de connexion (SW) pour commander la connexion desdites lignes de transmission de données auxdites lignes communes ;

(e) un premier décodeur (10) pour sélectionner au moins l'une de ladite pluralité de lignes de transmission de mots (W) ; et

(f) un second décodeur (20) pour commander la sélection de rangées de paires de lignes de transmission de données par les lignes de commande (YC) ;

caractérisée en ce que :

(i) chacune des lignes communes (I/O(0), I/O(1),...) est disposée entre les sous-ensembles de mémoire correspondants ;

(ii) chacun desdits moyens de connexion (SW, GC, GC') relie deux paires de lignes de transmission de données correspondantes à une ligne commune correspondante, chaque moyen de connexion (SW, GC, GC') comportant des moyens prévus en commun pour deux paires de lignes de transmission de données divisées correspondantes appartenant à différents sous-ensembles pour relier sélectivement une paire de deux paires de lignes de transmission de données à une ligne commune correspondante ;

(iii) au moins quatre desdits sous-ensembles (MA, MA', - -) sont disposés sur un côté dudit second décodeur (20), et sont disposés dans la direction desdites lignes de commande (YC), lesdits premier et second décodeurs (10, 20) étant agencés le long de deux côtés mutuellement perpendiculaires de ladite combinaison d'au moins quatre desdits sous-ensembles ;

(iv) des moyens de commande comportant lesdits seconds décodeurs (20) sont prévus pour exciter les lignes de commande (YC) ;

(v) lesdits moyens de connexion (SW) comportent un premier moyen de commutation (GC, GC') pour sélectionner une paire des paires de lignes de transmission de données correspondantes pour une connexion à l'amplificateur différentiel en fonction d'un premier signal ($\emptyset_{GC}$) appliqué sur une première ligne de commande, et un second moyen de commutation (SW), pour relier une paire de lignes de transmission de données sélectionnée par lesdits premiers moyens de commutation à une ligne commune correspondante en fonction d'un signal ($\emptyset_Y$) sur une ligne de commande correspondante (YC) ;

(vi) chacun desdits amplificateurs différentiels (SA) comprend des moyens pour amplifier différentiellement deux signaux sur la paire sélectionnée desdites lignes de transmission de données, lesquelles deux lignes de transmission de données sont sélectionnées par deux premiers moyens de commutation respectivement correspondants (GC, GC'), dans lesquels deux desdits premiers moyens de commutation reliés à deux desdites quatre lignes de transmission de données sont alimentés en commun par ledit premier signal, avec lesdits deux desdits premiers moyens de commutation couplés aux deux autres desdites quatre lignes de transmission de données recevant en commun un signal complémentaire audit premier signal lorsque l'une des deux desdites quatre lignes de transmission de données sont sélectionnées ; et

(vii) ledit dispositif de mémoire comporte en outre une pluralité de circuits de précharge (PC, Figure 5) afin de précharger lesdites deux paires de lignes de transmission de données.

2. Dispositif de mémoire selon la revendication 1, dans lequel ladite pluralité de lignes de commande (YC) sont disposées en parallèle avec ladite pluralité de paires de lignes de transmission de données.

3. Dispositif de mémoire selon la revendication 2, dans lequel des parties principales de ladite pluralité de lignes de commande (YC) sont constituées d'une couche différente de celle de parties principales desdites lignes de transmission de données.

4. Dispositif de mémoire selon la revendication 1, dans lequel lesdites lignes de transmission de données et lesdites lignes de commande (YC) sont toutes deux réalisées en aluminum.

5. Dispositif de mémoire selon la revendication 2, dans lequel lesdites lignes de commande (YC) entrecoupent lesdites lignes de transmission de données sur les parties médianes desdites lignes de transmission de données.

6. Dispositif de mémoire selon la revendication 1, dans lequel ledit second décodeur (20) comporte un circuit abaisseur ($Q_1$, $Q_2$) afin de maintenir les lignes de commande non sélectionnées à un potentiel à faible impédance.

7. Dispositif de mémoire selon la revendication 1, comportant en outre une pluralité de cellules fictives (DC) prévues chacune en commun pour deux lignes de transmission de données afin d'assurer une tension de référence à l'une desdites deux lignes de transmission de données qui est choisie par lesdits premiers moyens de commutation (GC, GC'), l'un desdits premiers moyens de commutation étant couplé à l'une desdites deux lignes de transmission de données et recevant ledit premier signal, et l'un desdits premiers moyens de commutation étant relié à l'autre desdites deux lignes de transmission de données et recevant un signal complémentaire dudit premier signal.

8. Dispositif de mémoire selon la revendication 1, dans lequel une pluralité de sous-ensembles (MA) constitués par lesdites lignes de transmission de mots (WL), les lignes de transmission de données (D) et les cellules de mémoire (MC) sont formés sur une puce, et chacune de ladite pluralité de lignes de commande (YC) est disposée à travers au moins l'un desdits sous-ensembles.

9. Dispositif de mémoire selon l'une quelconque des revendications précédentes, dans lequel ledit second décodeur (20) comporte un circuit abaisseur ($Q_1$, $Q_2$) afin de maintenir des lignes de commande non sélectionnées à un potentiel à faible impédance prédéterminé.

10. Mémoire à semiconducteurs selon l'une quelconque des revendications précédentes, dans laquelle la majorité desdites lignes de commande (YC) sont disposées dans une couche différente de celle desdites lignes de transmission de données.

11. Mémoire à semiconducteurs selon l'une quelconque des revendications précédentes, dans laquelle ladite paire desdites lignes de transmission de données sont disposées de manière à être sensiblement parallèles et à se croiser l'une l'autre dans au moins une partie.

**12.** Mémoire à semiconducteurs selon l'une quelconque des revendications précédentes, dans laquelle ledit second décodeur (20) possède des moyens d'excitation pour exciter respectivement les lignes sélectionnées.

**13.** Mémoire à semiconducteurs selon l'une quelconque des revendications précédentes, dans laquelle deux desdites lignes de transmission de données constituent conjointement une paire de structure de ligne repliée et lesdites lignes communes de signaux sont également disposées par paires.

**14.** Mémoire à semiconducteurs selon l'une quelconque des revendications précédentes, dans laquelle ledit second décodeur (20) possède des moyens ($Q_1$, $Q_2$) agissant pour fixer les lignes de commande non sélectionnées à un potentiel de non sélection.

**15.** Mémoire à semiconducteurs selon l'une quelconque des revendications précédentes, dans laquelle des moyens pour créer une tension de référence sont prévus pour chacune desdites lignes de transmission de données.

**16.** Mémoire à semiconducteurs selon l'une quelconque des revendications précédentes, dans laquelle la pluralité de circuits de précharge (PC, Figure 5) sont prévus chacun en commun pour lesdites deux paires de lignes de transmission de données.

**17.** Mémoire à semiconducteurs selon l'une quelconque des revendications précédentes, dans laquelle ladite pluralité de lignes de transmission de données et la pluralité de lignes communes sont disposées parallèles entre elles.

**18.** Mémoire à semiconducteurs selon l'une quelconque des revendications 1 à 16, dans laquelle ladite pluralité de lignes de transmission de données et la pluralité de lignes communes sont disposées perpendiculaires entre elles.

**19.** Mémoire à semiconducteurs selon l'une quelconque des revendications précédentes, dans laquelle ladite pluralité de lignes de commande (YC) sont disposées parallèlement à la direction du grand côté de la puce (31).

**20.** Mémoire à semiconducteurs selon l'une quelconque des revendications précédentes, dans laquelle ladite pluralité de lignes de commande (YC) sont disposées au milieu de ladite paire de pluralité de lignes de transmission de données.

**Patentansprüche**

**1.** Halbleiterspeichereinrichtung mit:

(a) einer Mehrzahl von Teil-Matrixanordnungen (MA, MA', - -), die jeweils eine Mehrzahl von Wortleitungen (W), eine Mehrzahl von Datenleitungen (D), die sich in einer solchen Richtung erstrecken, daß sie sich mit der Mehrzahl von Wortleitungen schneiden, sowie eine Mehrzahl von Speicherzellen (MC) aufweisen, wobei jede Speicherzelle (MC) an dem Schnittpunkt zwischen einer Wortleitung (W) und einem der Datenleitungspaare ($\overline{D_{00}}$; $D_{00}$; $D_{00}'$, $\overline{D_{00}'}$ - -) angeordnet ist und einen Kondensator (Cs) zur Speicherung eines Signales sowie einen Transistor (Q) zur Verbindung des Kondensators (Cs) mit einer entsprechenden Datenleitung (D) aufweist, wobei die Datenleitungen als gefaltete Datenleitungsstruktur ausgebildet und mit den Speicherzellen (MC) verbunden sind, und die Datenleitungspaare mit differentiellen Signalen beaufschlagt werden, und entsprechend mit geringem Abstand zueinander parallel angeordnet und mit entsprechenden Differentialverstärkern (SA) verbunden sind, wobei jeder Differentialverstärker gemeinsam mit zwei Datenleitungspaaren angeordnet ist und zwischen den entsprechenden Speicher-Teilmatrixanordnungen liegt;

(b) einer Mehrzahl von gemeinsamen Leitungen (I/O(0), I/O(1), - -), die jeweils gemeinsam mit mindestens zwei entsprechenden Datenleitungspaaren (D) angeordnet sind, wobei zwei der Mehrzahl von gemeinsamen Leitungen, die den Datenleitungspaaren entsprechen, ein Paar gemeinsamer Leitungen (I/O(0), $\overline{I/O}(1)$, ...) bilden;

(c) einer Mehrzahl von Einrichtungen (SW, GC, GC') zur Verbindung der zwei Paare entsprechender Datenleitungen (D) mit den gemeinsamen Leitungen;

(d) einer Mehrzahl von Steuerleitungen (YC), von denen jede mindestens eine entsprechende Verbindungseinrichtung (SW) steuert, um die Verbindung der Datenleitungen mit den gemeinsamen Leitungen zu beeinflussen;

(e) einem ersten Dekoder (10) zur Auswahl mindestens einer Wortleitung (W) aus der Mehrzahl von Wortleitungen; und

(f) einem zweiten Dekoder (20) zu Steuerung der Auswahl der Reihen von Datenleitungspaaren mittels der Steuerleitungen (YC); dadurch gekennzeichnet, daß:

(i) jede der gemeinsamen Leitungen (I/O-(0), I/O(1), ...) zwischen entsprechenden Speicher-Teilmatrixanordnungen liegt;

(ii) jede der Verbindungseinrichtungen (SW, GC, GC') zwei Paare entsprechender Datenleitungen mit einer entsprechenden gemeinsamen Leitung verbindet, wobei jede Verbindungseinrichtung (SW, GC, GC') Einrichtungen aufweist, die gemeinsam für zwei Paare von entsprechenden geteilten Datenleitungen vorgesehen sind, die zu verschiedenen Teil-Matrixanordnungen gehören, um selektiv eines der beiden Datenleitungspaare mit einer entsprechenden gemeinsamen Leitung zu verbinden;

(iii) mindestens vier der Teil-Matrixanordnungen (MA, MA', - -) auf einer Seite des zweiten Dekoders (20) angeordnet sind und in Richtung der Steuerleitungen (YC) verlaufen, wobei die ersten und zweiten Dekoder (10, 20) entlang zweier zueinander senkrechter Seiten der Kombination aus mindestens vier der Teil-Matrixanordnungen angeordnet sind;

(iv) Treibereinrichtungen für die Steuerleitungen (YC) in dem zweiten Dekoder (20) vorgesehen sind;

(v) die Verbindungseinrichtung (SW) eine erste Schalteinrichtung (GC, GC') zur Auswahl eines Paares der entsprechenden Datenleitungspaare zur Verbindung mit dem Differentialverstärker in Abhängigkeit von einem an eine erste Steuerleitung angelegten ersten Signal ($\emptyset_{GC}$), sowie eine zweite Schalteinrichtung (SW) aufweist, um ein durch die erste Schalteinrichtung ausgewähltes Datenleitungspaar mit einer entsprechenden gemeinsamen Leitung in Abhängigkeit von einem Signal ($\emptyset_Y$) auf einer entsprechenden Steuerleitung (YC) zu verbinden;

(vi) jeder der Differentialverstärker (SA) Einrichtungen zur differentiellen Verstärkung von zwei Signalen auf den ausgewählten Datenleitungspaaren aufweist, wobei die zwei Datenleitungen durch zwei entsprechende erste Schalteinrichtungen (GC, GC') ausgewählt werden, und wobei zwei der ersten Schalteinrichtungen, die mit zwei der vier Datenleitungen verbunden sind, gemeinsam mit dem ersten Signal beaufschlagt werden, und die zwei der ersten Schalteinrichtungen, die mit den anderen zwei der vier Datenleitungen verbunden sind, gemeinsam mit einem gegenüber dem ersten Signal komplementären Signal beaufschlagt werden, wenn jeweils zwei der vier Datenleitungen ausgewählt werden; und

(vii) die Speichereinrichtung weiterhin eine Mehrzahl von Vor-Ladeschaltungen (PC, Fig. 5) aufweist, um die zwei Datenleitungspaare mit einer Basisladung zu beaufschlagen.

2. Speichereinrichtung nach Anspruch 1, dadurch gekennzeichnet, daß die Mehrzahl von Steuerleitungen (YC) parallel zu der Mehrzahl von Datenleitungspaaren angeordnet ist.

3. Speichereinrichtung nach Anspruch 2, dadurch gekennzeichnet, daß die Hauptteile der Mehrzahl von Steuerleitungen (YC) aus einer Schicht gebildet sind, die sich von der Schicht der Hauptteile der Datenleitungen unterscheidet.

4. Speichereinrichtung nach Anspruch 1, dadurch gekennzeichnet, daß die Datenleitungen und die Steuerleitungen (YC) aus Aluminium gebildet sind.

5. Speichereinrichtung nach Anspruch 2, dadurch gekennzeichnet, daß die Steuerleitungen (YC) die Datenleitungen in ihren mittleren Bereichen überschneiden.

6. Speichereinrichtung nach Anspruch 1, dadurch gekennzeichnet, daß der zweite Dekoder (20) eine Schaltung ($Q_1$, $Q_2$) aufweist, mit der nicht ausgewählte Steuerleitungen auf einem niedrigen Impedanzpotential gehalten werden.

7. Speichereinrichtung nach Anspruch 1, gekennzeichnet durch eine Mehrzahl von Blindzellen (DC), die jeweils gemeinsam für zwei Datenleitungen vorgesehen sind, um eine Bezugsspannung an eine der zwei Datenleitungen anzulegen, die durch die ersten Schalteinrichtungen (GC, GC') ausgewählt worden ist, wobei eine der ersten Schalteinrichtungen mit einer der zwei Datenleitungen verbunden ist und mit dem ersten Signal beaufschlagt wird, und eine der ersten Schalteinrichtungen mit der anderen der zwei Datenleitungen verbunden ist und mit einem gegenüber dem ersten Signal komplementären Signal beaufschlagt wird.

8. Speichereinrichtung nach Anspruch 1, dadurch gekennzeichnet, daß die Mehrzahl der Teil-Matrixanordnungen (MA), die aus den Wortleitungen (WL), den Datenleitungen (D) und den Speicherzellen (MC) aufgebaut sind, auf einem Chip gebildet sind und jede der Mehrzahl von Steuerleitungen (YC) durch mindestens eine der Teil-Matrixanordnungen geführt ist.

9. Speichereinrichtung nach einem der vorhergehenden Ansprüche, dadurch gekennzeichnet, daß der zweite Dekoder (20) eine Schaltung ($Q_1$, $Q_2$) aufweist, mit der nicht ausgewählte Steuerleitungen auf einem vorbestimmten, niedrigen Impedanzpotential gehalten werden.

10. Halbleiterspeicher nach einem der vorhergehenden Ansprüche, dadurch gekennzeichnet, daß der überwiegende Teil der Steuerleitungen (YC) in einer Schicht angeordnet ist, die von derjenigen der Datenleitungen verschieden ist.

11. Halbleiterspeicher nach einem der vorhergehenden Ansprüche, dadurch gekennzeichnet, daß das Paar Datenleitungen so angeordnet ist, daß es im wesentlichen parallel verläuft und sich mindestens mit einem Abschnitt überschneidet.

12. Halbleiterspeicher nach einem der vorhergehenden Ansprüche, dadurch gekennzeichnet, daß der zweite Dekoder (20) Treibereinrichtungen zum entsprechenden Treiben der ausgewählten Leitungen aufweist.

13. Halbleiterspeicher nach einem der vorhergehenden Ansprüche, dadurch gekennzeichnet, daß zwei der Datenleitungen ein Paar mit gefalteter Bitstruktur bilden und die gemeinsamen Signalleitungen ebenfalls paarweise angeordnet sind.

14. Halbleiterspeicher nach einem der vorhergehenden Ansprüche, dadurch gekennzeichnet, daß der zweite Dekoder (20) Einrichtungen ($Q_1$, $Q_2$) zum Halten der nicht ausgewählten Steuerleitungen auf einem entsprechenden Potential aufweist.

15. Halbleiterspeicher nach einem der vorhergehenden Ansprüche, dadurch gekennzeichnet, daß Einrichtungen zur Erzeugung einer Bezugsspannung für jede Datenleitung vorgesehen sind.

16. Halbleiterspeicher nach einem der vorhergehenden Ansprüche, dadurch gekennzeichnet, daß die Mehrzahl der Vor-Ladeschaltungen (PC, Fig. 5) jeweils gemeinsam für die zwei Paare der Datenleitungen vorgesehen sind.

17. Halbleiterspeicher nach einem der vorhergehenden Ansprüche, dadurch gekennzeichnet, daß die Mehrzahl der Datenleitungen und die Mehrzahl der gemeinsamen Leitungen parallel zueinander angeordnet sind.

18. Halbleiterspeicher nach einem der Ansprüche 1 bis 16, dadurch gekennzeichnet, daß die Mehrzahl der Datenleitungen und die Mehrzahl der gemeinsamen Leitungen senkrecht zueinander angeordnet sind.

19. Halbleiterspeicher nach einem der vorhergehenden Ansprüche, dadurch gekennzeichnet, daß die Mehrzahl der Steuerleitungen (YC) parallel zu der Richtung der langen Seite des Chips (31) angeordnet ist.

20. Halbleiterspeicher nach einem der vorhergehenden Ansprüche, dadurch gekennzeichnet, daß die Mehrzahl der Steuerleitungen (YC) in der Mitte des Paares der Mehrzahl von Datenleitungen angeordnet ist.

FIG. 1 PRIOR ART

EP 0 068 645 B1

# FIG. 2

EP 0 068 645 B1

## FIG. 3

Dout Di

WE →
A →

RWC — 30

EP 0 068 645 B1

# FIG. 4A

# FIG. 4B

FIG. 4C

FIG. 5

# FIG. 6

Fig 7

Fig 8

# FIG. 9

# FIG. 10

CONTROL CIRUIT ⟋31

PRC 2

YC3

YC2

YC1

YC0

X DEC

CONTROL CIRUIT ⟋32

20

EP 0 068 645 B1

## FIG. 11

## FIG. 12

# FIG. 13

# FIG. 14

# FIG. 15

# FIG. 16

# FIG. 17

FIG. 18

EP 0 068 645 B1

# FIG. 19

# FIG. 20

# F/G. 2/

FIG. 22

FIG. 23

34

FIG. 24

IOC₀ IOC₁ IOC₂ IOC₃

SA₂

SAIO

SAIO

SA₁

X DEC

GCL'

GCL

W DWL₁

DC

MC

$\phi_{GC}'$

$\phi_{GC}$

10